# EUROPEAN PATENT APPLICATION

(11) **EP 4 668 343 A1**
(43) Date of publication of application: **24.12.2025**
(21) Application number: 23921737.5
(22) Date of filing: 15.02.2023
(51) Int. Cl.: H01L 33/62, H01L 27/15

(54) **LIGHT-EMITTING CHIP, LIGHT-EMITTING SUBSTRATE AND DISPLAY APPARATUS**

(71) Applicant: BOE Technology Group Co., Ltd., Beijing 100015 (CN)
(72) Inventor: LI, Haixu, Beijing 100176 (CN); CAO, Zhanfeng, Beijing 100176 (CN); YUAN, Guangcai, Beijing 100176 (CN); ZHAO, Xinxin, Beijing 100176 (CN)
(74) Representative: Haseltine Lake Kempner LLP
(86) International application number: PCT/CN2023/076128
(87) International publication number: WO 2024/168573

(57) **Abstract**

Provided in the present application are a light-emitting chip, a light-emitting substrate and a display apparatus. The light-emitting chip comprises a pixel circuit layer, a light-emitting unit group located on one side of the pixel circuit layer, and a plurality of conductive pads located on the side of the pixel circuit layer facing away from a light-emitting unit(s); the pixel circuit layer comprises at least part of the structure of a pixel circuit and a plurality of signal lines; the light-emitting unit group comprises at least one light-emitting unit, and the light-emitting unit(s) is/are electrically connected to the pixel circuit; one of the conductive pads is electrically connected to one of the signal lines; the light-emitting substrate comprises a plurality of light-emitting chips and a second driving circuit, and the plurality of conductive pads are connected to the second driving circuit; and the display apparatus comprises the light-emitting substrate.

## Description

### TECHNICAL FIELD

The present disclosure relates to display technology, and in particular to a light-emitting chip, a light-emitting device and a display apparatus.

### BACKGROUND

Micro light-emitting diodes (LEDs), including Mini LED and Micro LED, are about less than 500 µm in size. Due to their smaller size, ultra-high brightness, long life and other advantages, there is a significant increase in their usage trend in the display field.

### SUMMARY

The present disclosure provides a light-emitting chip, a light-emitting device and a display apparatus.

The first aspect of embodiments of the present disclosure provides a light-emitting chip, and the light-emitting chip includes:
a pixel circuit layer, where the pixel circuit layer includes at least a part of a structure of the pixel circuit and a plurality of signal lines;
a light-emitting unit group located on a side of the pixel circuit layer, where the light-emitting unit group includes at least one light-emitting unit, and the at least one light-emitting unit is electrically connected with the pixel circuit;
a plurality of conductive pads located on a side of the pixel circuit layer facing away from the light-emitting unit, where one of the conductive pads is electrically connected with one of the signal lines.

In an embodiment, the light-emitting unit includes a first electrode and a second electrode, the light-emitting chip further includes a first binding electrode and a second binding electrode located between the pixel circuit layer and the light-emitting unit; the first binding electrode is electrically connected with the pixel circuit and the first electrode; the second binding electrode is electrically connected with one signal line of the signal lines and electrically connected with the second electrode.

In an embodiment, the light-emitting chip further includes a first protective layer, where the first protective layer includes a first part located on a side of the pixel circuit layer facing towards the light-emitting unit and a second part covering a side surface of the pixel circuit layer.

In an embodiment, the light-emitting chip further includes a first substrate between the pixel circuit layer and the plurality of conductive pads, where the first substrate is provided with a plurality of through holes, one of the conductive pads is electrically connected with the signal line via one of the through holes; and
the first protective layer further includes a third part formed by extending an end of the second part facing towards the first substrate in a direction away from the pixel circuit layer, where the third part is in contact with the first substrate.

In an embodiment, the light-emitting chip further includes a first substrate between the pixel circuit layer and the plurality of conductive pads, the first substrate is provided with a plurality of through holes, one of the conductive pads is electrically connected with the signal line via one of the through holes; and
the light-emitting chip further includes a second protective layer, where the second protective layer includes a fourth part located on a side of the first substrate facing towards the conductive pad and a fifth part covering a side surface of the first substrate.

In an embodiment, the pixel circuit layer is provided with an opening connected with the through hole, the light-emitting chip further includes a conductive structure located in the opening and the through hole, where the conductive pad is electrically connected with the signal line through the conductive structure; and the second protective layer further includes a sixth part, which covers a side surface of the opening and a side surface of the through hole.

In an embodiment, the light-emitting chip further includes a first substrate between the pixel circuit layer and the plurality of conductive pads, where the first substrate is provided with a plurality of through holes, one of the conductive pads is electrically connected with the signal line via one of the through holes; the first substrate includes a rigid substrate layer.

In an embodiment, the light-emitting chip further includes a first substrate between the pixel circuit layer and the plurality of conductive pads, the first substrate is provided with a plurality of through holes, one of the conductive pads is electrically connected with the signal line via one of the through holes; the first substrate includes at least two organic substrate layers.

In an embodiment, the light-emitting unit includes a first electrode and a second electrode, where the pixel circuit layer covers the first electrode and the second electrode; and the pixel circuit layer includes a connection trace, where an end of the connection trace is electrically connected with the pixel circuit, the other end of the connection trace is connected with the first electrode.

In an embodiment, at least a part of an orthographic projection of the structure of the pixel circuit in the pixel circuit on the light-emitting unit is located between the first electrode and the second electrode.

In an embodiment, the orthographic projection of the structure of the pixel circuit in the pixel circuit on a plane where a surface of the first electrode is located at least partially falls within the surface of the first electrode; or, the orthographic projection of the structure of the pixel circuit in the pixel circuit on a plane where a surface of the second electrode is located at least partially falls within the surface of the second electrode.

In an embodiment, the pixel circuit layer includes a thin-film transistor, the thin-film transistor includes an active layer;
when the orthographic projection of the pixel circuit on the plane where the surface of the first electrode is located at least partially falls within the surface of the first electrode, the orthographic projection of the active layer on the plane where the surface of the first electrode is located falls within the surface of the first electrode; or, when the orthographic projection of the pixel circuit on the plane where the surface of the second electrode is located at least partially falls within the surface of the second electrode, the orthographic projection of the active layer on the plane where the surface of the second electrode is located falls within the surface of the second electrode.

In an embodiment, the light-emitting unit group includes at least two light-emitting units with different emission colors, the second electrodes of at least two of the light-emitting units are electrically connected, and the electrically connected second electrodes are electrically connected with one of the conductive pads.

In an embodiment, at least two of the light-emitting units share the second electrode.

In an embodiment, the light-emitting chip further includes a first drive circuit configured to provide a drive signal to the pixel circuit, and the first drive circuit is electrically connected with the plurality of signal lines.

In an embodiment, the light-emitting unit includes a first electrode and a second electrode, where at least a part of an orthographic projection of the structure of the pixel circuit in the pixel circuit on the light-emitting unit is located between the first electrode and the second electrode.

In an embodiment, the light-emitting chip further includes a protective layer located on a side of the light-emitting unit facing away from the pixel circuit layer.

In an embodiment, the light-emitting unit includes a light-emitting layer and an optical film layer located on a side of the light-emitting layer facing away from the pixel circuit layer.

In an embodiment, the light-emitting unit is Mini LED or Micro LED.

The second aspect of embodiments of the present disclosure provides a light-emitting device, which includes the light-emitting chips described above and a second drive circuit, where the plurality of conductive pads are connected with the second drive circuit.

In an embodiment, the light-emitting device includes an encapsulation layer, where the encapsulation layer covers the side surfaces of each of the light-emitting chips and light-emitting surfaces of the light-emitting chips.

The third aspect of the embodiments of the present disclosure provides a display apparatus, which includes the light-emitting device described above.

In the light-emitting chip, the light-emitting device and the display apparatus provided by the embodiments of the present disclosure, the pixel circuit layer includes at least a part of the structure of the pixel circuit and a plurality of signal lines, so the structure of the drive backplane for driving the light-emitting chip can be simplified, the optionality of the drive backplane is increased, and the drive backplane can be designed regardless of the density of the pixel circuit, which helps improve the utilization of the substrate in the drive backplane.

### BRIEF DESCRIPTION OF DRAWINGS

FIG. 1 is a cross-sectional view of a light-emitting chip according to an exemplary embodiment of the present disclosure;
FIG. 2 is a cross-sectional view of a light-emitting chip according to another exemplary embodiment of the present disclosure;
FIG. 3 is a cross-sectional view of a light-emitting chip according to another exemplary embodiment of the present disclosure;
FIG. 4 is a cross-sectional view of a light-emitting chip according to another exemplary embodiment of the present disclosure;
FIG. 5 is a block diagram of a light-emitting device according to an exemplary embodiment of the present disclosure;
FIG. 6 is a cross-sectional view of a light-emitting chip according to another exemplary embodiment of the present disclosure;
FIG. 7 is a partial structural diagram of a light-emitting chip according to an exemplary embodiment of the present disclosure;
FIG. 8 is a cross-sectional view of a first intermediate structure of a light-emitting chip according to an exemplary embodiment of the present disclosure;
FIG. 9 is a cross-sectional view of a second intermediate structure of a light-emitting chip according to an exemplary embodiment of the present disclosure;
FIG. 10 is a cross-sectional view of a third intermediate structure of a light-emitting chip according to an exemplary embodiment of the present disclosure;
FIG. 11 is a cross-sectional view of a fourth intermediate structure of a light-emitting chip according to an exemplary embodiment of the present disclosure;
FIG. 12 is a cross-sectional view of a fifth intermediate structure of a light-emitting chip according to an exemplary embodiment of the present disclosure;
FIG. 13 is a cross-sectional view of a sixth intermediate structure of a light-emitting chip according to an exemplary embodiment of the present disclosure;
FIG. 14 is a cross-sectional view of a seventh intermediate structure of a light-emitting chip according to an exemplary embodiment of the present disclosure;
FIG. 15 is a cross-sectional view of a eighth intermediate structure of a light-emitting chip according to an exemplary embodiment of the present disclosure;
FIG. 16 is a cross-sectional view of a ninth intermediate structure of a light-emitting chip according to an exemplary embodiment of the present disclosure;
FIG. 17 is a cross-sectional view of a tenth intermediate structure of a light-emitting chip according to an exemplary embodiment of the present disclosure;
FIG. 18 is a cross-sectional view of an eleventh intermediate structure of a light-emitting chip according to an exemplary embodiment of the present disclosure;
FIG. 19 is a cross-sectional view of the eleventh intermediate structure of a light-emitting chip according to another exemplary embodiment of the present disclosure;
FIG. 20 is a cross-sectional view of a twelfth intermediate structure of a light-emitting chip according to an exemplary embodiment of the present disclosure;
FIG. 21 is a partial cross-sectional view of the twelfth intermediate structure illustrated in FIG. 20; and
FIG. 22 is a partial cross-sectional view of a light-emitting device according to an exemplary embodiment of the present disclosure.

### DETAILED DESCRIPTION

Exemplary embodiments will be described in detail here, examples of which are illustrated in the accompanying drawings. When the following description relates to the accompanying drawings, unless specified otherwise, the same numerals in different drawings represent the same or similar elements. The implementations described in the following exemplary embodiments do not represent all implementations consistent with the present disclosure. Conversely, they are merely examples of apparatuses and methods consistent with some aspects of the present disclosure as detailed in the appended claims.

The terms used in this disclosure are merely for the purpose of describing specific embodiments, and are not intended to limit this disclosure. The terms "a", "said" and "the" of singular forms used in this disclosure and the appended claims are also intended to include plural forms, unless the context clearly indicates otherwise. It should also be understood that, the term "and/or" used herein indicates and includes any or all possible combinations of one or more associated listed items.

It should be understood that although the terms such as first, second, and third may be used herein to describe various information, such information should not be limited to these terms. These terms are only used to distinguish information of the same category with each other. For example, without departing from the scope of the present disclosure, first information may be referred as second information; and similarly, second information may also be referred as first information. Depending on the context, the word "if" as used herein may be interpreted as "when" or "upon" or "in response to determining".

The embodiments of the present disclosure provide a light-emitting chip, a light-emitting device and a display apparatus. The light-emitting chip, the light-emitting device and the display device in the embodiments of present disclosure are described in detail below with reference to the accompanying drawings. If there is no conflict, features in the embodiments described below may complement each other or be combined with each other.

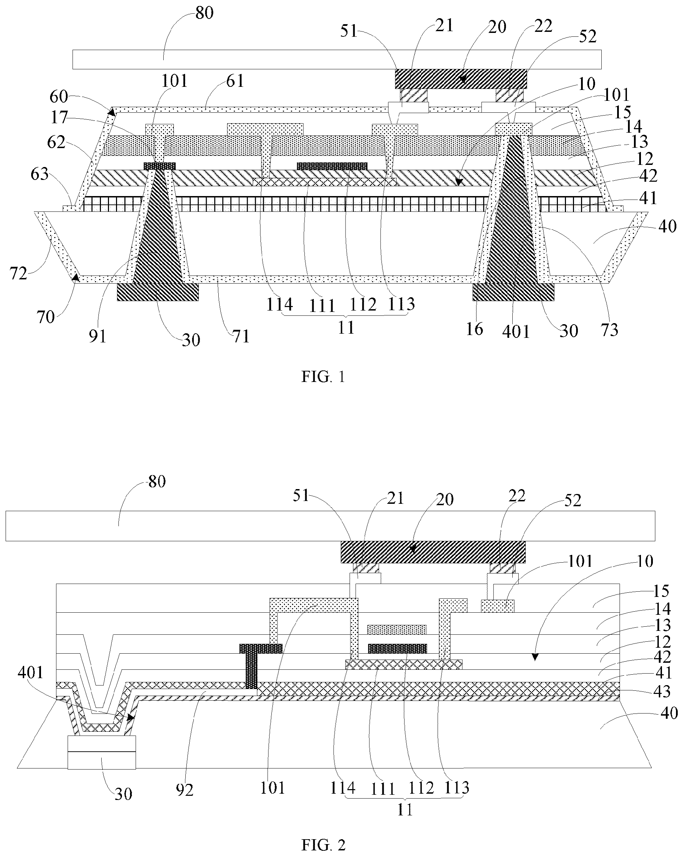

Embodiments of the present disclosure provide a light-emitting chip. As illustrated in FIG. 1 to FIG. 4, the light-emitting chip includes a pixel circuit layer 10, a light-emitting unit group and a plurality of conductive pads 30.

The pixel circuit layer 10 includes at least a part of the structure of the pixel circuit and a plurality of signal lines 101. The light-emitting unit group is located on a side of the pixel circuit layer 10, the light-emitting unit group includes at least one light-emitting unit 20, and the light-emitting unit 20 is electrically connected with the pixel circuit. The plurality of conductive pads 30 are located on a side of the pixel circuit layer 10 facing away from the light-emitting unit 20, and one of the conductive pads 30 is electrically connected with one of the signal lines 101. The signal line 101 may include a constant voltage signal line and a drive signal line used to provide a drive signal to the pixel circuit. For example, the constant voltage signal line may include high-level power supply lines, low-level power supply lines, ground lines, etc., and the drive signal line may include scan signal lines, data signal lines, reset signal lines, light-emitting control signal lines, etc. The conductive pad 30 is used to electrically connect with the drive circuit in the drive backplane driving the pixel circuit, so that the drive backplane can provide signals to the signal lines through the conductive pad 30.

The light-emitting chip provided by the embodiments of the present disclosure includes a pixel circuit layer, the pixel circuit layer includes at least a part of the structure of the pixel circuit and a plurality of signal lines, so the structure of the drive backplane for driving the light-emitting chip can be simplified, the optionality of the drive backplane is increased, and the drive backplane can be designed regardless of the density of the pixel circuit, which helps improve the utilization of the substrate in the drive backplane.

In an embodiment, the light-emitting chip further includes a first drive circuit configured to provide a drive signal to the pixel circuit, and the first drive circuit is electrically connected with the plurality of signal lines. The first drive circuit may be, for example, a gate drive circuit, a source drive circuit, etc. This arrangement can reduce the quantity of conductive pads of the light-emitting chip.

In an embodiment, the pixel circuit includes a plurality of transistors and at least one capacitor. For example, the pixel circuit may be a 7T1C circuit, a 11T3C circuit, a 2T1C circuit, or a 7T2C circuit, etc.

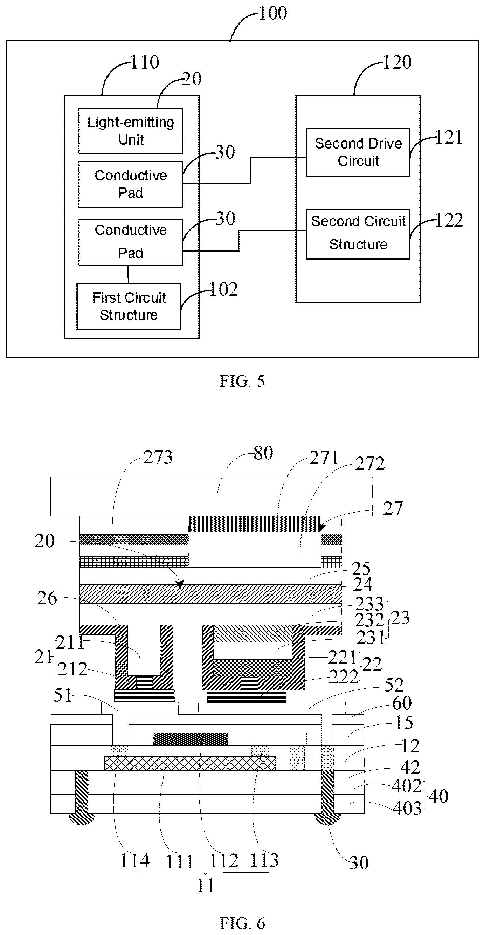

In an embodiment, the entire structure of the pixel circuit is located in the pixel circuit layer. In another embodiment, a part of the structure of the pixel circuit is located in the pixel circuit layer, another part of the structure of the pixel circuit may be located in the drive backplane used to drive the light-emitting chip; when the light-emitting chip is transferred to the drive backplane, the structure of the pixel circuit located in the light-emitting chip is bonded to the structure of the pixel circuit located in the drive backplane. As illustrated in FIG. 5, the light-emitting device 100 in which the light-emitting chip is located includes a light-emitting chip 110 and a drive backplane 120, the pixel circuit used to drive the light-emitting unit 20 includes the first circuit structure 102 located in the light-emitting chip 110 and the second circuit structure 122 located in the drive backplane 120, and the first circuit structure 102 and the second circuit structure 122 are electrically connected. The first circuit structure 102 and the second circuit structure 122 may both be connected with the conductive pads 30, so that the first circuit structure 102 and the second circuit structure 122 are electrically connected through the conductive pads 30. The drive backplane 120 includes the second drive circuit 121, and the second drive circuit 121 is electrically connected with the conductive pads 30 of the light-emitting chip 110 and is used to provide a drive signal to the conductive pads 30.

In an embodiment, the pixel circuit and the light-emitting unit can correspond one to one, and each pixel circuit drives the corresponding light-emitting unit.

In an embodiment, as illustrated in FIG. 1 to FIG. 4, the pixel circuit includes a thin-film transistor 11, the thin-film transistor 11 includes an active layer 111, a gate electrode 112, a first pole 113 and a second pole 114. One of the first pole113 and the second pole 114 is a source electrode, and the other is a drain electrode. The first pole 113 and the second pole 114 are arranged on the same layer. The first pole 113 is electrically connected with the first electrode 21 of the light-emitting unit 20. The material of the active layer 111 may be a low-temperature polysilicon material or a metal oxide semiconductor material.

In some implementations, the light-emitting unit 20 may be a Mini LED or a Micro LED, the size of Mini LED is approximately 100 µm~500 µm, and the size of Micro LED is less than 100µm.

In an embodiment, as illustrated in FIG. 1 and FIG. 2, the light-emitting unit 20 includes the first electrode 21 and the second electrode 22, the light-emitting chip further includes the first binding electrode 51 and the second binding electrode 52 located between the pixel circuit layer 10 and the light-emitting unit 20; the first binding electrode 51 is electrically connected with the pixel circuit, and the first electrode 21 is electrically connected with the first binding electrode 51; the second binding electrode 52 is electrically connected with one signal line 101, and the second electrode 22 is electrically connected with the second binding electrode 52. One of the first electrode 21 and the second electrode 22 is an anode, and the other is a cathode. In the embodiment, the process of preparing the light-emitting chip includes: first, preparing an intermediate structure including a pixel circuit layer, the first binding electrode, the second binding electrode, and a light-emitting unit; then, binding the first electrode 21 of the light-emitting unit 20 and the first binding electrode 51 of the intermediate structure, and binding the second electrode 22 and the second binding electrode 52 of the intermediate structure. In this way, a light-emitting chip is obtained.

In an embodiment, as illustrated in FIG. 1 and FIG. 2, the gate 112 is located on the side of the active layer 111 facing towards the light-emitting unit 20, the pixel circuit layer 10 further includes a gate insulation layer 12 located between the active layer 111 and the gate 112, an interlayer dielectric layer 13 located at a side of the gate 112 facing away from the active layer 111, a passivation layer 14 located on a side of the interlayer dielectric layer 13 facing away from the active layer 111, and a planarization layer 15 located on a side of the passivation layer 14 facing away from the active layer 111. The first pole 113 and the second pole 114 are partially located between the planarization layer 15 and the passivation layer 14, partially located in the through holes penetrating the gate insulation layer 12, the interlayer dielectric layer 13 and the passivation layer 14, and in partial contact with the conductive active layer 111. One of the first pole 113 and the second pole 114 is a source electrode, and the other is a drain electrode. The first electrode 21 is electrically connected with the first pole 113 via a through hole penetrating the planarization layer 15.

As illustrated in FIG. 1 and FIG. 2, the light-emitting chip further includes the first substrate 40 located at a side of the pixel circuit layer 10 facing away from the light-emitting unit 20. The pixel circuit layer 10 is formed on a side of the first substrate 40.

In an embodiment, as illustrated in FIG. 1, the first substrate 40 is located between the pixel circuit layer 10 and the conductive pad 30, the first substrate 40 is provided with a plurality of through holes 401, and one of the conductive pads 30 is electrically connected with the signal line 101 via one of the through holes 401.

In an embodiment, as illustrated in FIG. 1, the pixel circuit layer 10 is provided with an opening 16 connected with the through hole 401, the light-emitting chip further includes a conductive structure 91 located in the opening 16 and the through hole 401, and the conductive pad 30 is electrically connected with the signal line 101 through the conductive structure 91.

In an embodiment, as illustrated in FIG. 1, the pixel circuit layer 10 further includes a connection structure 17, the connection structure 17 is located between the signal line 101 and the conductive structure 91, and at least one of the signal lines 101 is electrically connected with the conductive structure 91 through the connection structure 17. The connection structure 17 may be arranged on the same layer as the conductive structure included in the pixel circuit, for example, it may be arranged on the same layer as the gate 112.

In an embodiment, as illustrated in FIG. 2, the conductive pad 30 may be located in the through hole 401 of the first substrate 40, and the surface of the conductive pad 30 facing away from the light-emitting unit 20 exposes the through hole 401. The light-emitting chip further includes a fan-out line 92 located between the first substrate 40 and the pixel circuit layer 10, the fan-out line 92 is connected with the conductive pad 30, and the signal line 101 is electrically connected with the fan-out line 92, so that the signal line 101 is electrically connected with the conductive pad 30 through the fan-out line 92.

Further, as illustrated in FIG. 2, the light-emitting chip further includes an insulation layer 43 located between the fan-out line 92 and the first substrate 40.

In an embodiment, as illustrated in FIG. 1, the light-emitting chip further includes the first protective layer 60, where the first protective layer 60 includes the first part 61 located on a side of the pixel circuit layer 10 facing towards the light-emitting unit 20 and the second part 62 covering a side surface of the pixel circuit layer 10. The first part 61 is connected with the second part 62. The first protective layer 60 can prevent water and oxygen from intruding into the conductive structure of the pixel circuit in the pixel circuit layer 10, which helps improve the reliability of the light-emitting chip. The first part 61 is provided with an opening, the first binding electrode 51 is electrically connected with the first electrode 21 through the opening of the first part 61, and the second binding electrode 52 is electrically connected with the second electrode 22 through the opening of the first part 61.

In an embodiment, the material of the first protective layer 60 is an inorganic material, for example, the material of the first protective layer 60 includes at least one of silicon oxide and silicon nitride. The thickness of the first protective layer 60 is more than or equal to 1,000 Angstroms, in this manner, the effect of the first protective layer 60 preventing water and oxygen is better. In some embodiments, the thickness of the first protective layer 60 may be more than or equal to 3,000 Angstroms.

In an embodiment, the first protective layer 60 further includes the third part 63 formed by extending an end of the second part 62 facing towards the first substrate 40 in a direction away from the pixel circuit layer 10, and the third part 63 is in contact with the first substrate 40. The third part 63 can effectively prevent water and oxygen from intruding into the conductive structure of the pixel circuit layer 10 through the gap between the first substrate 40 and the pixel circuit layer 10, further improving the effect of the first protective layer 60 preventing water and oxygen.

Further, the width of the third part 63 may be more than or equal to 1.7 µm. Since deviations exist in the preparation process, there may be cases where the second part 62 cannot completely cover the side surfaces of the pixel circuit layer 10 during the preparation of the first protective layer 60. By setting the width of the third part 63 to be more than or equal to 1.7 µm, in the case of maximum process deviation, it can ensure that the first protective layer 60 completely covers the side surfaces of the pixel circuit layer 10.

In an embodiment, as illustrated in FIG. 1, the light-emitting chip further includes the second protective layer 70, where the second protective layer 70 includes the fourth part 71 located on a side of the first substrate 40 facing away from the light-emitting unit 20 and the fifth part 72 covering a side surface of the first substrate 40. The fourth part 71 is connected with the fifth part 72. The second protective layer 70 can prevent water and oxygen from intruding into the pixel circuit layer 10 through the first substrate 40, further improving the reliability of the light-emitting chip.

As illustrated in FIG. 1, the conductive pad 30 is located on a side of the first substrate 40 facing away from the light-emitting unit 20, the fourth part 71 is located on a side of the first substrate 40 facing towards the conductive pad 30, the fourth part 71 is provided with an opening, and the conductive pad 30 is electrically connected with the conductive structure 91 through the opening of the fourth part 71. When the conductive pad 30 is located in the through hole 401 of the first substrate 40, the fourth part 71 is provided with an opening, and the surface of the conductive pad 30 exposes the opening of the fourth part 71.

In an embodiment, as illustrated in FIG. 1, the second protective layer 70 further includes the sixth part 73 covering the side surface of the opening 16 and the side surface of the through hole 401. The sixth part 73 can prevent water and oxygen from intruding to the pixel circuit layer 10 through the gap between the conductive structure of 91 and the side surface of the opening 16 and the through hole 40, which can further improve the effect of the second protective layer 70 preventing water and oxygen.

In an embodiment, the material of the second protective layer 70 is an inorganic material, for example, the material of the second protective layer 70 includes at least one of silicon oxide and silicon nitride. The thickness of the second protective layer 70 is more than or equal to 1,000 Angstroms, in this manner, the effect of the second protective layer 70 preventing water and oxygen is better. In some embodiments, the thickness of the second protective layer 70 may be more than or equal to 3,000 Angstroms.

In an embodiment, as illustrated in FIG. 1 and FIG. 2, the light-emitting chip further includes a barrier layer 41 and a buffer layer 42, located between the first substrate 40 and the pixel circuit layer 10, and the buffer layer 42 is located on a side of the barrier layer 41 facing away from the first substrate 40.

In an embodiment, as illustrated in FIG. 6, the light-emitting chip is obtained by transferring the light-emitting unit to the pixel circuit layer 10, and the first substrate 40 includes a rigid substrate layer 403. After the light-emitting unit is transferred to the pixel circuit layer, it needs to perform die bonding. With this arrangement, the rigidity of the first substrate 40 is larger, so during the die bonding process, the first substrate 40 has a better supporting effect on the structure located above the first substrate, which can improve the yield of the die bonding process and meanwhile avoid the problem that the low hardness of the first substrate leads to the uneven compression of the first substrate in the die bonding process, where the problem further leads to the pixel circuit structure of the pixel circuit layer fails.

In some embodiments, the rigid substrate layer includes any one of a glass substrate layer, a quartz substrate layer, a sapphire substrate layer, a silicon substrate, etc.

In some embodiments, as illustrated in FIG. 6, the first substrate 40 may further include a flexible substrate layer 402, the flexible substrate layer 402 may be located on a side of the rigid substrate layer 403 facing towards the light-emitting unit 20, and the flexible substrate layer 402 can improve the adhesion between the pixel circuit layer 10 and the rigid substrate. The material of the flexible substrate layer 402 may include one or more of polyimide, polyethylene terephthalate, polycarbonate, and organic resin materials, where the organic resin materials may include epoxy resin, triazine, silicone resin or polyimide, etc.

In order to verify the die bonding yield of the light-emitting chips when the first substrate 40 includes a rigid substrate, 30 number of light-emitting chips are tested separately, where the first chip in each of 15 number of light-emitting chips includes a rigid substrate layer, and each of the other 15 number of light-emitting chips only includes a flexible substrate layer. After testing, the following test results were obtained: when the first substrate 40 includes a rigid substrate layer, the die bonding of 14 number of light-emitting chips out of the 15 number of light-emitting chips can meet the requirements; when the first substrate 40 only includes a flexible substrate layer, the die bonding of only 9 number of light-emitting chips out of the 15 number of light-emitting chips can meet the requirements. It can be known that, when the first substrate 40 includes a rigid substrate, the die bonding yield of the light-emitting chip can be effectively improved.

In another embodiment, when the light-emitting chip is transferred from the light-emitting unit to the pixel circuit layer 10, the first substrate 40 includes at least two organic substrate layers. After the light-emitting unit is transferred to the pixel circuit layer, it needs to perform die bonding. The first substrate 40 includes at least two organic substrate layers, which can increase the rigidity of the first substrate 40 and improve the yield of the die-bonding process, and meanwhile can avoid the problem that the pixel circuit structure of the pixel circuit layer fails in the die bonding process; and compared with the solution in which the first substrate 40 includes a rigid substrate layer, it is easier to provide through holes in the first substrate 40, which helps reduce the difficulty of the preparation process and can also improve the toughness of the overall structure of the light-emitting chip.

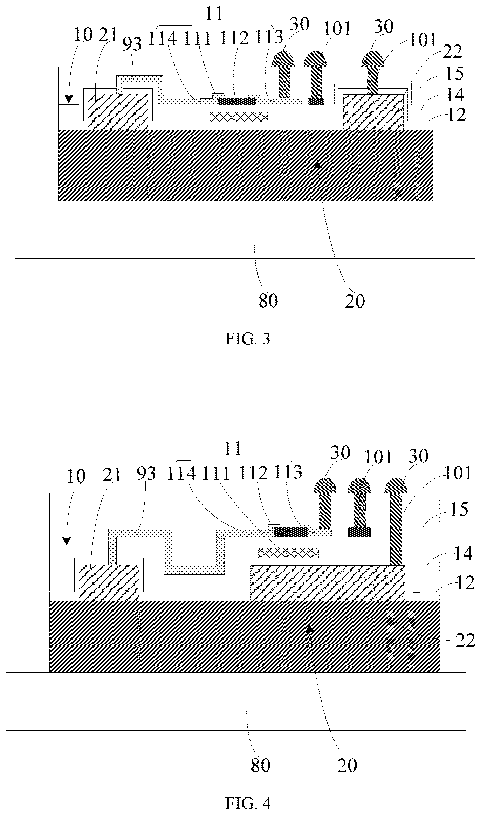

In an embodiment, the pixel circuit layer may be formed on the light-emitting chip. As illustrated in FIG. 3 and FIG. 4, the pixel circuit layer 10 covers the first electrode 21 and the second electrode 22; the pixel circuit layer 10 includes a connection trace 93, an end of the connection trace 93 is electrically connected with the pixel circuit, and the other end of the connection trace 93 is connected with the first electrode 21. The connection trace 93 may overlap the second electrode 114 of the thin-film transistor 11. With this arrangement, the first electrode 21 is electrically connected with the pixel circuit through the connecting trace 93, and does not need to perform binding, so there is no need to provide a binding electrode, which helps improve the yield of the light-emitting chip and simplify the preparation process; since the pixel circuit layer 10 is formed on the light-emitting unit 20, there is no need to provide the first substrate 40, which helps reduce the thickness of the light-emitting chip. The connection trace 93 may be arranged on the same layer as the second pole 114, that is, both are formed in the same process step, which helps simplify the preparation process.

In an embodiment, as illustrated in FIG. 3, at least a part of the orthographic projection of the structure of the pixel circuit in the pixel circuit layer 10 on the light-emitting unit 20 is located between the first electrode 21 and the second electrode 22. In some embodiment, when the gap between the first electrode 21 and the second electrode 22 is large enough, the orthographic projection of the structure of the pixel circuit in the pixel circuit layer on the light-emitting unit 20 can be completely located between the first electrode 21 and the second electrode 22. This arrangement helps reduce the overall thickness of the light-emitting chip.

In another embodiment, as illustrated in FIG. 4, an orthographic projection of the structure of the pixel circuit in the pixel circuit layer on a plane where a surface of the second electrode 22 is located at least partially falls within the surface of the second electrode 22. In other embodiments, an orthographic projection of the structure of the pixel circuit in the pixel circuit layer on a plane where a surface of the first electrode 21 is located at least partially falls within the surface of the first electrode 21. This arrangement helps reduce the size of the light-emitting chip, which helps increase the quantity of light-emitting chips in a light-emitting device where the light-emitting chip is located on the premise of a fixed size of the light-emitting device.

Further, as illustrated in FIG. 4, the orthographic projection of the pixel circuit on the plane where the surface of the second electrode 22 is located at least partially falls within the surface of the second electrode 22, and the orthographic projection of the active part 111 of the thin-film transistor 11 on the plane where the surface of the second electrode 22 is located falls within the surface of the second electrode 22. In other embodiments, the orthographic projection of the structure of the pixel circuit on the plane where the surface of the first electrode 21 is located at least partially falls within the surface of the first electrode 21, and the orthographic projection of the active part 111 of the thin-film transistor 11 on the plane where the surface of the first electrode 21 is located falls within the surface of the first electrode 21. This arrangement can avoid gaps between different parts of the active layer 111 that would affect the characteristics of the thin-film transistor. In some embodiments, when the size of the first electrode 21 is large enough, the orthographic projection of the structure of the pixel circuit in the pixel circuit 10 on the plane where the surface of the first electrode 21 is located can completely fall on the surface of the first electrode 21; or, when the size of second electrode 22 is large enough, the orthographic projection of the structure of the pixel circuit in the pixel circuit 10 on the plane where the surface of the second electrode 22 is located can completely fall on the surface of the second electrode 22.

In an embodiment, the light-emitting unit group includes at least two light-emitting units 20 with different emission colors, the second electrodes 22 of at least two of the light-emitting units 20 are electrically connected, and the electrically connected second electrodes 22 are electrically connected with one of the conductive pads 30. This arrangement can save the quantity of conductive pads 30 and help simplify the preparation process. In some embodiments, the second electrode 22 of each light-emitting unit 20 in the light-emitting unit group is electrically connected with the same conductive pad 30, which can further reduce the quantity of conductive pads 30.

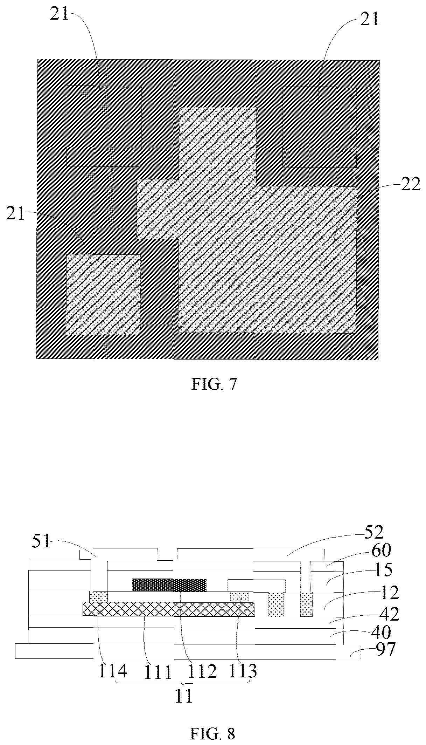

In an embodiment, at least two of the light-emitting units share the second electrode 22. This can save the quantity of conductive pads 30 and the second electrodes 22, which helps reduce the size of the light-emitting chip and simplifies the preparation process. In some embodiments, each of the light-emitting units 20 in the light-emitting unit group shares one second electrode 22. As illustrated in FIG. 7, the light-emitting chip includes three light-emitting units, and the three light-emitting units share the second electrode 22.

In an embodiment, the light-emitting unit group includes light-emitting units 20 with three emission colors, which are separately: a light-emitting unit 20 with the red emission color, a light-emitting unit 20 with the green emission color, and a light-emitting unit 20 with the blue emission color.

In an embodiment, when the at least two light-emitting units 20 share the second electrode 22, at least a part of an orthographic projection of the pixel circuit on the light-emitting unit is located between the first electrode 21 and the second electrode 22. In the case that at least two light-emitting units 20 share the second electrode 22, the total area of the second electrodes 22 of all light-emitting units 20 decreases, which can increase the distance between the first electrode 21 and the second electrode 22 on the premise of a fixed size of the light-emitting chip, so that at least a part of the orthographic projection of the pixel circuit on the light-emitting unit can be located between the first electrode 21 and the second electrode 22.

In an embodiment, when the light-emitting unit group includes at least two light-emitting units 20 with different emission colors, the light-emitting chip further includes the first drive circuit. With this arrangement, each light-emitting unit of the light-emitting unit group can share the first drive circuit, which does not increase the size of the light-emitting chip too much on the premise of reducing the quantity of conductive pads of the light-emitting chip.

In an embodiment, as illustrated in FIG. 1 to FIG. 4, the light-emitting chip further includes a protective layer 80 located on a side of the light-emitting unit 20 facing away from the pixel circuit layer 10. The protective layer 80 can protect the light-emitting unit 20. The protective layer 80 has a relatively high light transmittance, and most of the light line emitted by the light-emitting unit 20 can be emitted through the protective layer 80. The material of the protective layer 80, for example, may be glass, or the material of the protective layer 80 includes polyethylene terephthalate (PET), polycarbonate (PC), etc. In this manner, the light transmittance of the protective layer 80 can be higher, and the hardness of the protective layer 80 can be larger, which improves the anti-pressure capability and anti-collision capability of the light-emitting chip and has better protection effect for the underlying film layer and light-emitting units.

In an embodiment, the light-emitting unit 20 is formed on the protective layer 80. That is, the protective layer 80 serves as a base during the preparation process of the light-emitting unit 20, and at the same time can protect the light-emitting unit 20.

In an embodiment, as illustrated in FIG. 6, the light-emitting unit 20 further includes a light-emitting layer 23, where the light-emitting layer 23 includes the first semiconductor layer 231, a quantum well layer 232 located on a side of the first semiconductor layer 231 facing away from the pixel circuit layer 10, and the second semiconductor layer 233 located on a side of the quantum well layer 232 facing away from the pixel circuit layer 10. The first electrode 21 is in contact with the second semiconductor layer 233, the second electrode 22 is in contact with the first semiconductor layer 231, and the first electrode 21 and the second electrode 22 are located on the same side of the second semiconductor layer 233. One of the first semiconductor layer 231 and the second semiconductor layer 233 is an n-type semiconductor layer, and the other is a p-type semiconductor layer. For example, when the first electrode 21 is a cathode and the second electrode 22 is an anode, the first semiconductor layer 231 is a p-type semiconductor layer and the second semiconductor layer 233 is an n-type semiconductor layer.

In an embodiment, as illustrated in FIG. 6, the first electrode 21 includes the first sub-electrode 211 and the second sub-electrode 212 located on a side of the first sub-electrode 211 facing the pixel circuit layer 10, and the second electrode 22 includes the third sub-electrode 221 and the fourth sub-electrode 222 located on a side of the third sub-electrode 221 facing the pixel circuit layer 10. The light-emitting unit 20 further includes an insulation layer 26, where the insulation layer 26 covers the first sub-electrode 211, the first semiconductor layer 231, the quantum well layer 232 and the side surfaces of the third sub-electrode 221, and covers a side of the second semiconductor layer 233 facing the pixel circuit layer 10. The second sub-electrode 212 is electrically connected with the first sub-electrode 211 through a via hole provided on the insulation layer 26, and the fourth sub-electrode 222 is electrically connected with the third sub-electrode 221 through the via hole provided on the insulation layer 26. The second sub-electrode 212 is bound to the first binding electrode 51, and the fourth sub-electrode 222 is bound to the second binding electrode 52.

In an embodiment, as illustrated in FIG. 6, the light-emitting chip 20 further includes an optical film layer 27 located on a side of the light-emitting layer 23 facing away from the pixel circuit layer 10.

In an embodiment, the optical film layer 27 includes a quantum dot layer 271, where the quantum dot layer 271 can change the color of the light emitted by the light-emitting layer 23, for example, the quantum dot layer 271 can convert the blue light emitted by the light-emitting layer 23 into green light or red light, thereby achieving color display of the display device where the light-emitting chip is located.

In an embodiment, the optical film layer 27 includes a scattering film layer 272, where the diffusing film layer 272 can enhance the scattering degree of the light line emitted by the light-emitting unit 20, increasing the viewing angle of the light-emitting chip.

In an embodiment, the light-emitting unit 20 includes a light-emitting area and a non-light-emitting area, the quantum dot layer 271 and the scattering film layer 272 are located in the light-emitting area, and the optical film layer 27 further includes a light line adjustment layer 273 located in the non-light-emitting area. The light line transmittance of the light line adjustment layer 273 is relatively low, or the light line adjustment layer 273 may be a black film layer, for example, the light line adjustment layer 273 may be coated with a resin material with a relatively low transmittance. The light line adjustment layer 273 can effectively reduce the reflectivity of ambient light incident to the light-emitting chip, improving the user experience.

In an embodiment, the light-emitting chip further includes a bonding layer 24 and a buffer film layer 25 located on a side of the bonding layer 24 facing away from the light-emitting layer 23, the optical film layer 27 is located on a side of the buffer film layer 25 facing away from the light-emitting layer 23, and the buffer film layer 25 and the light-emitting layer 23 are bonded through the bonding layer 24. The bonding layer 24 may be a u-GaN bonding layer.

In an embodiment, at least a part of the signal line 101 is arranged on the same layer as the structure of the pixel circuit in the pixel circuit layer, which helps to simplify the preparation process of the light-emitting chip.

In an embodiment, the material of the conductive pad 30 may include at least one of Sn, SnAg alloy, In, etc.

The embodiments of the present disclosure provide a preparation method of a light-emitting chip. The preparation method of the light-emitting chip is used to prepare the light-emitting chip as illustrated in FIG. 1 or FIG. 6. The preparation method of the light-emitting chip includes the following steps:

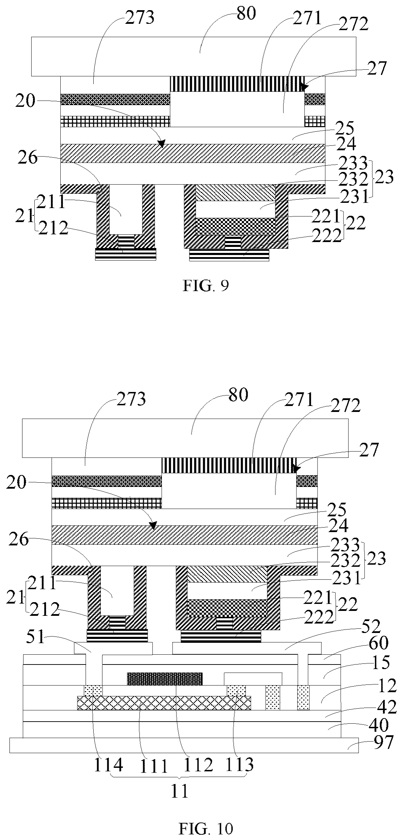

First, forming the first intermediate structure as illustrated in FIG. 8 and the second intermediate structure as illustrated in FIG. 9. The first intermediate structure includes the second substrate 97, the first substrate 40 located on the second substrate 97, the pixel circuit layer 10 located on a side of the first substrate 40 facing away from the second substrate 97, and the first binding electrode 51 and the second binding electrode 52 located on a side of the pixel circuit layer 10 facing away from the first substrate 40. The second intermediate structure includes the protective layer 80 and a light-emitting unit 20 located on a side of the protective layer 80.

Subsequently, the first intermediate structure and the second intermediate are bonded, to bond the first electrode 21 and the first binding electrode 51 and bond the second electrode 22 and the second binding electrode 52, to obtain the third intermediate structure as illustrated in FIG. 10.

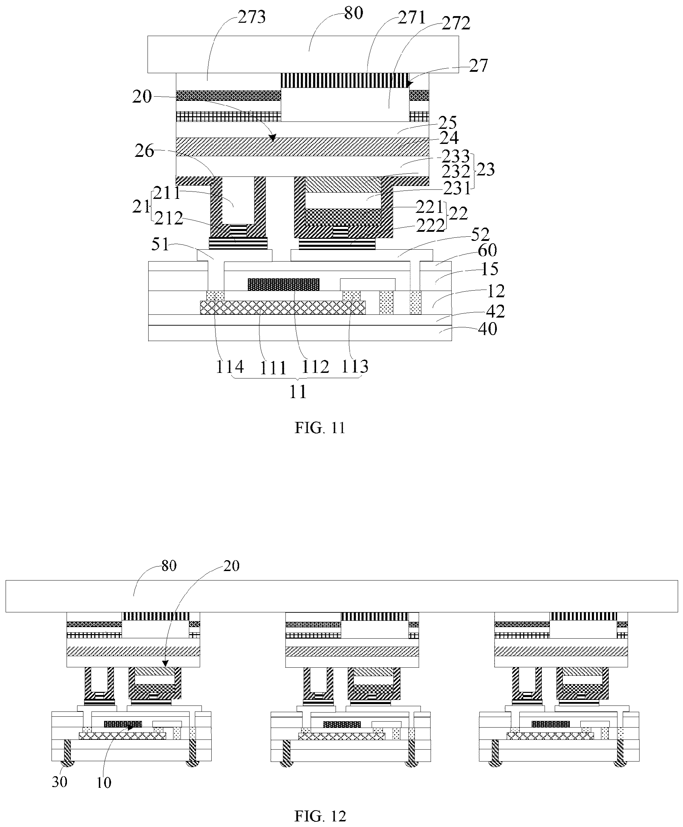

Subsequently, the second substrate 97 are peeled off, to obtain the fourth intermediate structure as illustrated in FIG. 11.

Subsequently, the through hole 401 are formed on the first substrate 40, and the conductive structure located in the through hole 401 and the conductive pad 30 located on a side of the first substrate facing away from the pixel circuit layer 10 are prepared, then the light-emitting chip as illustrated in FIG. 6 or FIG. 1 can be obtained.

In an embodiment, during the process of preparing the first intermediate structure, a pixel circuit film layer may be first formed on the substrate, and the pixel circuit film layer includes at least a part of the structure of a plurality of pixel circuits; subsequently, the insulation layer of the pixel circuit film layer is etched to obtain a plurality of pixel circuit layers with a plurality of intervals; and subsequently, the first substrate is cut, to obtain the first intermediate structure as illustrated in FIG. 8.

In an embodiment, after etching the insulation layer of the pixel circuit film layer, the first protective layer may be formed, where the first protective layer covers a side of the pixel circuit layer facing away from the first substrate and the side part of the pixel circuit layer.

In an embodiment, after forming the through hole 401 on the first substrate 40, the second protective layer may be formed, and the second protective layer covers a side of the first substrate 40 facing away from the first pixel circuit layer 10, the side surface of the first substrate 40 and the side surface of the through hole 401.

In an embodiment, the size of the protective layer 80 in the second intermediate structure is larger, for example, the size of the protective layer 80 is 4 inches, the second intermediate structure may include a plurality of light-emitting unit groups located on the protective layer 80, and after forming the conductive pad 30, the fifth intermediate structure is obtained as illustrated in FIG. 12. Afterwards, the protective layer 80 of the fifth intermediate structure is thinned and cut, then the light-emitting chip can be obtained as illustrated in FIG. 1 and FIG. 6.

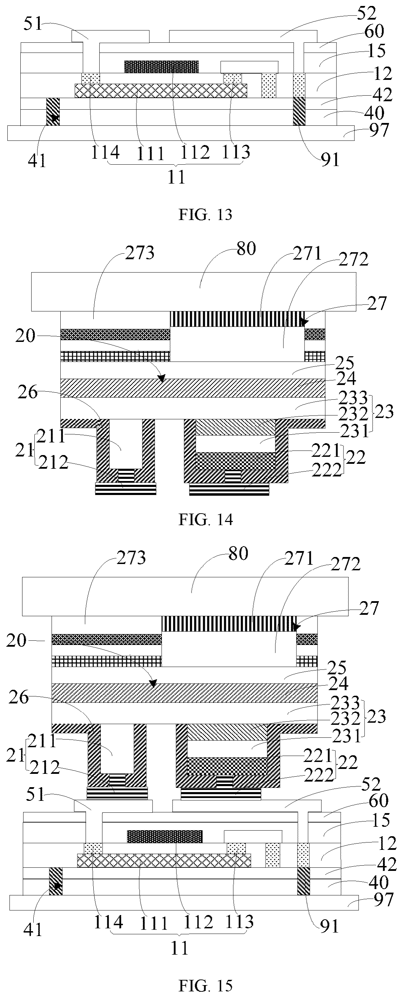

The embodiments of the present disclosure provide another preparation method of a light-emitting chip. The preparation method of the light-emitting chip is used to prepare the light-emitting chip as illustrated in FIG. 1 or FIG. 6. The preparation method of the light-emitting chip includes the following steps:
First, forming the sixth intermediate structure as illustrated in FIG. 13 and the seventh intermediate structure as illustrated in FIG. 14. The sixth intermediate structure includes the second substrate 97, the first substrate 40 located on the second substrate 97, the pixel circuit layer 10 located on a side of the first substrate 40 facing away from the second substrate 97, and the first binding electrode 51 and the second binding electrode 52 located on a side of the pixel circuit layer 10 facing away from the first substrate 40; the first substrate 40 is provided with the through hole 401, and the conductive structure 91 is formed in the through hole 401. The seventh intermediate structure includes the protective layer 80 and a light-emitting unit 20 located on a side of the protective layer 80.

Subsequently, the sixth intermediate structure and the seventh intermediate structure are bonded, to bond the first electrode 21 and the first binding electrode 51 and bond the second electrode 22 and the second binding electrode 52, to obtain the eighth intermediate structure as illustrated in FIG. 15.

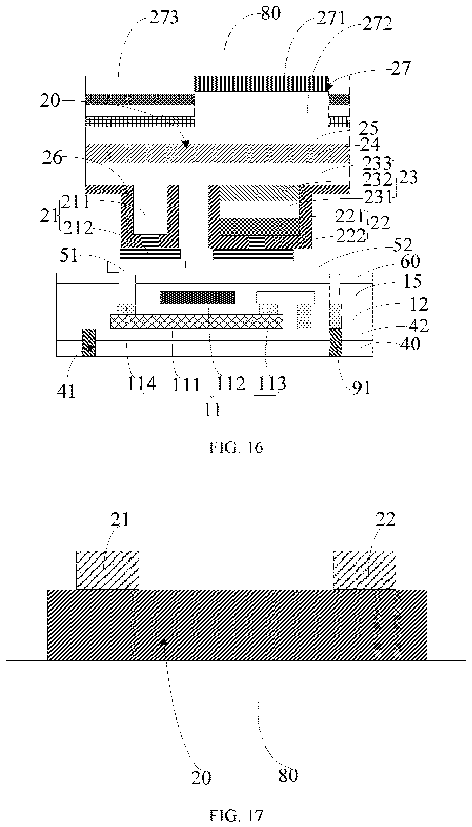

Subsequently, the second substrate 97 is peeled off, to obtain the ninth intermediate structure as illustrated in FIG. 16.

Subsequently, the conductive pad 30 located on a side of the first substrate facing away from the pixel circuit layer 10 is formed, then the light-emitting chip can be obtained as illustrated in the FIG. 6 or FIG. 1.

In an embodiment, the seventh intermediate structure includes a plurality of light-emitting unit groups located on the protective layer 80, and after forming the conductive pad 30, the fifth intermediate structure is obtained as illustrated in FIG. 12. After thinning the protective layer 80 of the fifth intermediate structure and cutting the protective layer 80, the light-emitting chip can be obtained as illustrated in FIG. 1 and FIG. 6.

The embodiments of the present disclosure further provide another preparation method of a light-emitting chip. The preparation method of the light-emitting chip is used to prepare the light-emitting chip as illustrated in FIG. 3 or FIG. 4. The preparation method of the light-emitting chip includes the following steps.

First, forming the light-emitting unit 20 on the protective layer 80, and the first electrode 21 and the second electrode 22 of the light-emitting unit 20 are facing away from the protective layer 80, to obtain the tenth intermediate structure as illustrated in FIG. 17.

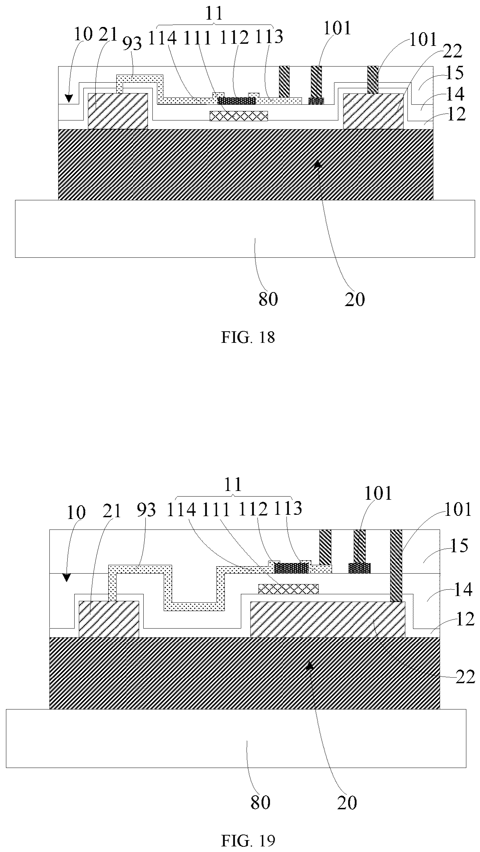

Subsequently, the pixel circuit layer 10 are formed on a side of the ninth intermediate structure facing away from the protective layer 80, to obtain the eleventh intermediate structure as illustrated in FIG. 18 or FIG. 19.

Subsequently, the conductive pad 30 is formed on a side of the pixel circuit layer 10 facing away from the protective layer 80, to obtain the light-emitting chip as illustrated in the FIG. 3 or FIG. 4.

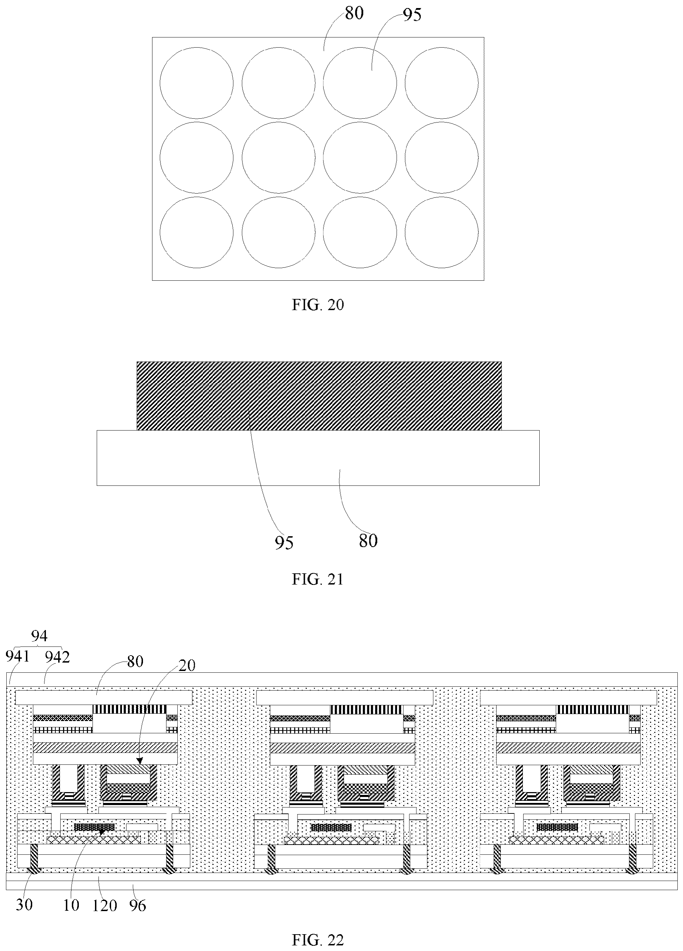

In an embodiment, the preparation process of the tenth intermediate structure may be as follows:
First, as illustrated in FIG. 20 and FIG. 21, a plurality of wafers 95 are mounted on the protective layer 80, where each wafer 95 includes the light-emitting layer of each light-emitting unit in a light-emitting unit group. By performing this step, the twelfth intermediate structure is obtained as illustrated in FIG. 20 and FIG. 21.

Subsequently, the first electrode 21 and the second electrode 22 are formed on a side of the wafer 95 facing away from the protective layer 80, to obtain the tenth intermediate structure as illustrated in FIG. 17. In the tenth intermediate structure, at least two of the light-emitting units 20 in the same light-emitting unit group share the second electrode 22.

The embodiments of the preparation method of a light-emitting device and the embodiments of the light-emitting device provided in the embodiments of the present disclosure belong to the same inventive concept, and the relevant details and descriptions of beneficial effects can be referred to each other and will not be described herein again.

The embodiments of the present disclosure further provide a light-emitting device, which includes a plurality of the light-emitting chips described in any one of the above embodiments and the second drive circuit, where the plurality of conductive pads are connected with the second drive circuit. The second drive circuit is used to provide drive signals to the pixel circuit of the light-emitting chip.

In an embodiment, as illustrated in FIG. 22, the light-emitting device further includes a drive backplane 120, the second drive circuit is located on the drive backplane 120, and the light-emitting chip is bonded to the drive backplane 120, thereby the plurality of conductive pads electrically are connected with the second drive circuit.

In an embodiment, the light-emitting device further includes the third substrate 96, and the drive backplane 120 is located on the third substrate 96.

In an embodiment, as illustrated in FIG. 22, the light-emitting device includes the encapsulation layer 94, where the encapsulation layer 94 covers the side surfaces of each of the light-emitting chips and a light-emitting surface of the light-emitting chip. The encapsulation layer 94 may protect the light-emitting unit 20.

In an embodiment, as illustrated in FIG. 22, the encapsulation layer 94 includes the first sub-encapsulation layer 941 that at least covers the side surface of the light-emitting chip and the second sub-encapsulation layer 942 located on a side of the first sub-encapsulation layer 941 facing away from the drive backplane 120. The light transmittance of the first sub-encapsulation layer 941 may be smaller than the light transmittance of the second sub-encapsulation layer 942, and the first sub-encapsulation layer 941 can avoid light line crosstalk between adjacent light-emitting chips. The first sub-encapsulation layer 941 may be black, or include a black film layer. The second sub-package layer 942 may be grey or black, which can improve the blackness of the light-emitting device in a state of no display.

The embodiments of the present disclosure further provide a display apparatus, which includes the light-emitting device described in any one of the above embodiments.

In some embodiments, the display apparatus may be a liquid crystal display apparatus, which includes a liquid crystal device and a backlight source disposed at the non-display side of the liquid crystal device, where the backlight source includes the above-mentioned light-emitting device.

In another embodiment, the light-emitting device in the display apparatus is used as a display device. When the light-emitting device is used as a display device, each light-emitting chip is used as a sub-pixel.

In an embodiment, the display apparatus further includes a housing, and the light-emitting device is embedded in the housing.

The display apparatus provided in the embodiments of the present disclosure may be any appropriate display apparatus, including but not limited to mobile phones, tablet computers, televisions, monitors, notebook computers, digital photo frames, navigators, e-books, and any other products or components with display functions.

The display apparatus provided in the embodiments of the present disclosure may be any appropriate display apparatus, including but not limited to mobile phones, tablet computers, televisions, monitors, notebook computers, digital photo frames, navigators, e-books, and any other products or components with display functions.

It is to be noted that in the accompanying drawings, the dimensions of layers and regions may be exaggerated for clarity of illustration. It will be understood that when an element or a layer is referred to as being "above" or "on" another element or layer, it may be directly on the other element, or intervening layers may be present. In addition, it will be understood that when an element or a layer is referred to as being "under" or "below" another element or layer, it may be directly under the other element, or one or more intervening layers or elements may be present. In addition, it will also be understood that when a layer or an element is referred to as being "between" two layers or two elements, it may be the only layer between the two layers or two elements, or one or more intervening layers or elements may be present. Like reference numerals indicate like elements throughout.

Those skilled in the art will readily conceive other embodiments of the present disclosure upon consideration of the specification and practice of the various embodiments disclosed herein. The present disclosure is intended to cover any variation, use, or adaptive change of this disclosure. These variations, uses, or adaptive changes follow the general principles of this disclosure and include common general knowledge or common technical means in the art that are not disclosed in this disclosure. The specification and the embodiments are considered as merely exemplary, and the real scope and spirit of the present disclosure are pointed out in the following claims.

It should be understood that this disclosure is not limited to the precise structures described above and illustrated in the accompanying drawings, and various modifications and changes may be made without departing from the scope of the present disclosure. The scope of the present disclosure is limited only by the appended claims.

## Claims

1. A light-emitting chip, comprising:
a pixel circuit layer comprising at least a part of a structure of a pixel circuit and a plurality of signal lines;
a light-emitting unit group on a side of the pixel circuit layer and comprising at least one light-emitting unit electrically connected with the pixel circuit; and
a plurality of conductive pads on a side of the pixel circuit layer facing away from the light-emitting unit, wherein one of the plurality of conductive pads is electrically connected with one of the plurality of signal lines.

2. The light-emitting chip according to claim 1, wherein the light-emitting unit comprises a first electrode and a second electrode, the light-emitting chip further comprises a first binding electrode and a second binding electrode between the pixel circuit layer and the light-emitting unit; wherein the first binding electrode is electrically connected with the pixel circuit and the first electrode; and wherein the second binding electrode is electrically connected with one signal line of the plurality of signal lines and electrically connected with the second electrode.

3. The light-emitting chip according to claim 2, further comprising a first protective layer comprising a first part on a side of the pixel circuit layer facing the light-emitting unit and a second part covering a side surface of the pixel circuit layer.

4. The light-emitting chip according to claim 3, further comprising a first substrate between the pixel circuit layer and the plurality of conductive pads, the first substrate comprising a plurality of through holes, wherein one of the plurality of conductive pads is electrically connected with one of the plurality of signal lines via one of the through holes; and
wherein the first protective layer further comprises a third part extending from an end of the second part facing towards the first substrate in a direction away from the pixel circuit layer, wherein the third part is in contact with the first substrate.

5. The light-emitting chip according to claim 1, further comprising a first substrate between the pixel circuit layer and the plurality of conductive pads, the first substrate comprising a plurality of through holes, wherein one of the plurality of conductive pads is electrically connected with one of the plurality of signal lines via one of the plurality of through holes; and
wherein the light-emitting chip further comprises a second protective layer comprising a fourth part on a side of the first substrate facing the conductive pads and a fifth part covering a side surface of the first substrate.

6. The light-emitting chip according to claim 5, wherein the pixel circuit layer comprises an opening connected with one of the plurality of through holes, wherein the light-emitting chip further comprises a conductive structure in the opening and the one of the plurality of through holes, wherein one of the plurality of conductive pads is electrically connected with one of the plurality of signal lines through the conductive structure; and wherein the second protective layer further comprises a sixth part, which covering a side surface of the opening and a side surface of the one of the plurality of through holes.

7. The light-emitting chip according to claim 2, further comprising a first substrate between the pixel circuit layer and the plurality of conductive pads, wherein the first substrate is provided with a plurality of through holes, and one of the conductive pads is electrically connected with one of the plurality of signal lines via one of the plurality of through holes; and the first substrate comprises a rigid substrate layer.

8. The light-emitting chip according to claim 2, wherein the light-emitting chip further comprises a first substrate between the pixel circuit layer and the plurality of conductive pads, wherein the first substrate is provided with a plurality of through holes, and one of the conductive pads is electrically connected with one of the plurality of signal lines via one of the plurality of through holes; and the first substrate comprises at least two organic substrate layers.

9. The light-emitting chip according to claim **1,** wherein the light-emitting unit comprises a first electrode and a second electrode; wherein the pixel circuit layer covers the first electrode and the second electrode; wherein the pixel circuit layer comprises a connection trace; wherein an end of the connection trace is electrically connected with the pixel circuit, and wherein another end of the connection trace is connected with the first electrode.

10. The light-emitting chip according to claim 9, wherein at least a part of an orthographic projection of the at least part of the structure of the pixel circuit in the pixel circuit on the light-emitting unit is between the first electrode and the second electrode.

11. The light-emitting chip according to claim 9, wherein an orthographic projection of the at least part of the structure of the pixel circuit in the pixel circuit on a plane in which a surface of the first electrode is located at least partially falls within the surface of the first electrode; or, wherein an orthographic projection of the structure of the pixel circuit in the pixel circuit on a plane in which a surface of the second electrode is located at least partially falls within the surface of the second electrode.

12. The light-emitting chip according to claim 11, wherein the pixel circuit layer comprises a thin-film transistor comprising an active layer;
when the orthographic projection of the pixel circuit on the plane where the surface of the first electrode is located at least partially falls within the surface of the first electrode, an orthographic projection of the active layer on the plane where the surface of the first electrode is located falls within the surface of the first electrode; or, when the orthographic projection of the pixel circuit on the plane where the surface of the second electrode is located at least partially falls within the surface of the second electrode, an orthographic projection of the active layer on the plane where the surface of the second electrode is located falls within the surface of the second electrode.

13. The light-emitting chip according to claim 1, wherein the light-emitting unit group comprises at least two light-emitting units with different emission colors, second electrodes of at least two of the light-emitting units are electrically connected, and the second electrodes are electrically connected with one of the plurality of conductive pads.

14. The light-emitting chip according to claim 13, wherein at least two of the light-emitting units share a second electrode.

15. The light-emitting chip according to claim 13, further comprising a first drive circuit configured to provide a drive signal to the pixel circuit, and the first drive circuit is electrically connected with the plurality of signal lines.

16. The light-emitting chip according to claim 14, wherein the light-emitting unit comprises a first electrode and a second electrode, wherein at least a part of an orthographic projection of the structure of the pixel circuit in the pixel circuit layer on the light-emitting unit is between the first electrode and the second electrode.

17. The light-emitting chip according to claim 1, further comprising a protective layer on a side of the light-emitting unit facing away from the pixel circuit layer.

18. The light-emitting chip according to claim **1,** wherein the light-emitting unit comprises a light-emitting layer and an optical film layer on a side of the light-emitting layer away from the pixel circuit layer.

19. The light-emitting chip according to claim **1,** wherein the light-emitting unit is Mini LED or Micro LED.

20. A light-emitting device, comprising: a plurality of light-emitting chips according to any one of claims 1 to 19 and a second drive circuit, wherein the plurality of conductive pads are connected with the second drive circuit.

21. The light-emitting device according to claim 20, wherein the light-emitting device comprises an encapsulation layer, wherein the encapsulation layer covers side surfaces of each of the plurality of light-emitting chips and light-emitting surfaces of the plurality of light-emitting chips.

22. A display apparatus, comprising the light-emitting device according to claim 20 or 21.
